# EUROPÄISCHE PATENTSCHRIFT

(11) **EP 0 585 204 B1**
(45) Veröffentlichungstag und Bekanntmachung des Hinweises auf die Patenterteilung: **25.09.1996**
(21) Anmeldenummer: 93810577.2
(22) Anmeldetag: 16.08.1993
(51) Int. Cl.: H05K 13/00, B65G 17/32

(54) **Verfahren und Vorrichtung zur Beschichtung von plattenförmigem Gut, insbesondere von Leiterplatten**
Process and apparatus for coating platelike products especially printed circuit boards
Procédé et dispositif pour le revêtement d'objets en forme de plaques en particulier cartes de circuit imprimé

(30) Priorität: 24.08.1992 CH 2636/92
(43) Veröffentlichungstag der Anmeldung: 02.03.1994
(73) Patentinhaber: CIBA-GEIGY AG, 4002 Basel (CH)
(72) Erfinder: Kuster, Kaspar, CH-4057 Basel (CH)

(56) Entgegenhaltungen:
- DE-A- 3 539 959
- DE-A- 3 738 067
- DE-C- 4 107 224

## Beschreibung

Die Erfindung betrifft ein Verfahren zur Beschichtung von plattenförmigem Gut, insbesondere von Leiterplatten gemäss Oberbegriff des Patentanspruchs 1. Weiters betrifft die Erfindung auch eine dafür geeignete Vorrichtung gemäss Oberbegriff des Patentanspruchs 12.

Leiterplatten werden nachdem sie mit Leiterbahnen versehen sind mit einer Schutzschicht beschichtet. Bei dieser Schutzschicht handelt es sich um einen vorzugsweise UV-härtbaren belichtbaren Kunststoff, Lack oder dergleichen. Nach dem Trocknen der Schutzschicht wird diese in geeigneter Form belichtet und an den belichteten Stellen herausentwickelt. An diesen Stellen liegen dann die Leiterbahnen frei und können elektrisch kontaktiert werden. Bei beidseitig mit Leiterbahnen versehenen Leiterplatten müssen beide Oberflächen der Platten beschichtet werden, ohne bei der Beschichtung der zweiten Seite die zuvor auf die erste Seite aufgebrachte Beschichtung zu beschädigen. Zum Beschichten müssen die Leiterplatten durch eine Reihe von Bearbeitungsstationen einer Beschichtunganlage transportiert werden. Dort werden die zuvor gereinigten Leiterplatten zunächst vorgewärmt, und auf einer Seite mit der Schutzschicht versehen. Dazu werden die zu beschichtenden Leiterplatten in einer Beschichtungsstation vorzugsweise unter einem frei fallenden Giessvorhang hindurch transportiert. Nach der Beschichtung der ersten Seite werden die Leiterplatten zu einer Abluft- und Trockenstation transportiert, in der das Lösungsmittel evaporiert (abgelüftet) wird und die beschichtete Oberfläche der Leiterplatten getrocknet wird. Soll auch die zweite Seite der Leiterplatten beschichtet werden, werden diese gewendet, erneut unter einem Giessvorhang feiner Beschichtungsstation hindurchtransportiert und schliesslich in einer Abluft- und Trockenstation abgelüftet und getrocknet.

Bei dem Transport der Leiterplatten von einer Bearbeitungstation zur nächsten, insbesondere beim Transport der Platten mit noch nasser Beschichtung und bei bereits einseitig beschichteten Leiterplatten, muss darauf geachtet werden, die Leiterplatte und die Beschichtung nicht zu beschädigen bzw. zu verletzen. Der Transport der Leiterplatten in den einzelnen Bearbeitungsstationen und von Station zu Station erfolgt mit Hilfe von verschiedenen automatischen Fördereinrichtungen. Die Tendenz, immer dünnere Leiterplattenmaterialien zu verwenden, wirft dabei jedoch das Problem auf, dass die Leiterplatten dazu neigen, sich während ihres Transportes und insbesondere aufgrund der Wärmebehandlung in der Vorwärmstation und in den Abluft- und Trockenstationen durchzubiegen und mit ihrer Unterseite an den Fördereinrichtungen oder Transportmitteln Berührung zu erlangen. Dies ist insbesondere dann sehr heikel, wenn die Leiterplatten beidseitig beschichtet werden sollen und dabei die noch weiche Schutzschicht an der Unterseite der Leiterplatten verletzt wird. Zudem können dabei auch die Fördereinrichtungen oder Transportmittel verschmutzen.

Vom Stand der Technik werden daher verschiedene Transportvorrichtungen und Halterungen für Leiterplatten in den verschiedenen Bearbeitungsstationen vorgeschlagen. In der US-A-5,113,701 wird vorgeschlagen, die Leiterplatten nach der Beschichtung in Halterahmen mit V-förmig auseinanderstehenden Zinken einzuschieben. Diese Halterahmen sind gerätefest mit einer Trockenstation verbunden und weisen eine fest vorgegebene Rahmenbreite auf. Ausserhalb der Trockenstation werden die Leiterplatten auf V-förmig angeordneten Rollenbahnen transportiert. Zwar werden bei dieser vorgeschlagenen Lösung die Leiterplatten im wesentlichen nur an ihren Längsrändern berührt und gestützt, jedoch kann es insbesondere bei sehr dünnen Leiterplatten grosser Länge und Breite dazu kommen, dass sie dennoch auf den Zinken der Halterahmen oder auf den Rollen der Rollenbahnen aufliegen. Dadurch und aufgrund der Tatsache, dass die Halterahmen und/oder die Rollenbahnen eine fest vorgegebene Breite aufweisen, können andere in den verschmutzten Rahmen transportierte Leiterplatten verunreinigt werden. Zudem erfordert die vorgeschlagene Beschichtungsanlage eine separate Zentrierstation, welche die Leiterplatten ausrichtet, bevor sie in der Beschichtungsstation unter dem Giessvorhang hindurchtransportiert werden.

In der US-A-4,926,789 sind Haltevorrichtungen für Leiterplatten beschrieben, welche Klammern umfassen, die die Leiterplatten an mehreren Punkten ihrer Längsränder fassen. In der vorgeschlagenen Beschichtungsanlage werden die Leiterplatten samt den Haltevorrichtungen von einer Bearbeitungsstation an die nächst übergeben. Erst ausgangs der Beschichtungsanlage werden die Haltevorrichtungen wieder von den Platten gelöst und wieder an den Eingang der Anlage zurücktransportiert. Die beschriebene Anlage ist relativ aufwendig in ihrer Konstruktion und erfordert gesonderte Zuführlifte, Transportbänder und Transportmittel für die Haltevorrichtungen. Auch müssen eingangs und ausgangs der Beschichtungsanlage Betätigungseinrichtungen für die Halteklammern der Haltevorrichtungen vorgesehen sein. Zudem besteht in der Beschichtungsstation die Gefahr, dass die Haltevorrichtungen beim Transport unter dem Giessvorhang hindurch verschmutzt werden.

In der US-A-4,848,533 ist eine Leiterplattentransportvorrichtung beschrieben, die zwei parallel zueinander umlaufende Ketten oder dgl. aufweist. Die Ketten sind mittels im Abstand voneinander angeordneten Traversen verbunden. Auf jeder Traverse sind zwei als Klemmen ausgebildete Halterungen gebremst gegeneinander verschiebbar gelagert. In einer Plattenaufnahmestation schieben zwei pneumatisch angetriebene Stössel die vorbeilaufenden Halterungen jeweils paarweise auf die Plattenlängsränder, wo sie sich festklemmen. Auf diese Weise werden mindestens zwei, üblicherweise jedoch mehrere Halterungspaare entlang der Längsränder einer Leiterplatte festgeklemmt, und diese derart gehalten entlang des Transportweges transportiert. In einer Plattenentladestation sind zwei weitere Stössel vorgesehen, welche die Halterungen wieder auseinanderschieben, wodurch die Leiterplatten wieder freigegeben werden. Bei der beschriebenen Transportvorrichtung werden die Leiterplatten durch mindestens zwei Halterungspaare an ihren Längsrändern gehalten, wobei sichergestellt ist, dass die Unterseite der Platten nicht mit den Transportketten oder mit den Traversen in Berührung kommt. Die Transportvorrichtung ist jedoch nur für den Horizontaltransport der Leiterplatten beispielsweise unter dem Giessvorhang hindurch ausgelegt. Um die Platten beispielsweise in die Trockenstation zu übergeben, müssen zunächst die Halterungen wieder entfernt werden, die Platten beispielsweise auf einen Rollenförderer umgeladen werden, über den sie dann in die Halterungen Trockenstation eingefahren werden können. Die Vorrichtung ist konstruktiv relativ aufwendig. Die vielen Halterungspaare, die auf den Traversen gegeneinander verschiebbar sein müssen, stellen eine mögliche Fehlerquelle dar. Beispielsweise könnten eine oder auch mehrere Traversen verschmutzt sein, was die Verschiebbarkeit der Halterungen stark beeinträchtigen kann, so dass ein zuverlässiges Ergreifen der Leiterplatten nicht mehr gewährleistet ist.

In der DE-A-35 39 959 ist ein Verfahren und eine Vorrichtung zum Transportieren von Leiterplatten durch Trocknungsanlagen beschrieben. Die beschichteten Leiterplatten laufen auf Transportbändern in die Trocknungsanlage ein, werden dort von Haltearmen, welche zu gerätefest mit der Trocknungsanlage verbundenen Plattenhaltern gehören, aufgenommen und durch diese Haltearme von den Transportbändern abgehoben. Der Abstand der Haltearme kann auf die Breite der zu transportierenden Leiterplatten eingestellt werden. Innerhalb der Trocknungsstation werden die Leiterplatten jeweils nur an zwei gegenüberliegenden Rändern gehalten. Problematisch an diesem Verfahren ist jedoch, dass die Leiterplatten vor ihrer Aufnahme durch die Haltearme mit ihrer Unterseite auf den Transportbändern aufliegen, denn hierbei besteht vor allem bei beidseitiger Beschichtung der Leiterplatten die Gefahr, dass die noch weiche Schutzschicht an der Unterseite der Leiterplatten verletzt wird. Zudem müssen die Leiterplatten vor ihrem Einfahren in die Trocknungsanlage ausgerichtet werden, um eine fehlerfreie Übernahme durch die Haltearme zu gewährleisten.

Es besteht daher die Aufgabe ein Verfahren und eine Vorrichtung zur Beschichtung von plattenförmigem Gut, insbesondere von Leiterplatten zu schaffen, welche den zuvor beschriebenen Nachteilen der Verfahren und Vorrichtungen des Standes der Technik Rechnung tragen und diese beheben. Insbesondere soll es das Verfahren erlauben, eine Leiterplatte verletzungsfrei durch eine Abluft- und Trockenstation mit vertikal umlaufenden Tragelementen zu transportieren und dabei zu wenden. Dabei soll die Leiterplatte im wesentlichen stets entlang ihrer beschichtungsfreien Längsränder geführt und unterstützt sein. Die Schnittstelle zwischen der Beschichtungsstation und der Abluft- und Trockenstation soll frei sein von Rollenbahnen oder ähnlichen Transportvorrichtungen. Die Leiterplatten sollen an ihren Längsseiten nicht geklemmt oder gefasst werden, aber dennoch geführt werden. Zudem soll auch sichergestellt sein, dass die Unterseiten der horizontal transportierten Leiterplatten auch in erwärmtem Zustand keine Berührung mit den Transportmitteln erleiden. Es sollen auch die Voraussetzungen für eine Beschichtungsanlage geschaffen werden, in der die Leiterplatten innerhalb der einzelnen Bearbeitungsstationen von unterschiedlichen Transportmitteln gehalten und/oder geführt werden und an den Schnittstellen an die Transportmittel der jeweils folgenden Bearbeitungsstation übergeben werden, wobei sie im wesentlichen ständig an ihren Längsrändern gestützt oder geführt werden. Eine Zentrierung der Leiterplatten soll nur mehr vor der ersten Beschichtung erforderlich sein, ab dort sollen die Leiterplatten in zentrierter Lage transportiert werden.

Die Lösung all dieser und noch weiterer damit zusammenhängender Aufgaben erfolgt durch ein Verfahren, das die im kennzeichnenden Teil des Patentanspruchs 1 angeführten Verfahrensschritte aufweist, und durch eine Vorrichtung mit den im kennzeichnenden Teil des Patentanspruchs 12 angegebenen Merkmalen. Besonders bevorzugte Verfahrensvarianten oder Ausführungsbeispiele der Vorrichtung sind Gegenstand der jeweils abhängigen Patentansprüche.

Im folgenden wird die Erfindung mit ihren erfindungswesentlichen Einzelheiten unter Bezugnahme auf die Zeichnungen näher erläutert. Es zeigen in zum Teil schematischer Darstellung:
- Fig. 1 bis 3: drei Ausführungsbeispiele der erfindungsgemässen Beschichtungsanlage mit unterschiedlichem Ausbaugrad,
- Fig. 4: eine Abluft- und Trockenstation der Beschichtungsanlagen gemäss Fig. 1 - 3 in Aufsicht,
- Fig. 5 und 6: Details der Befestigung von Tragelementen in der Abluft- und Trockenstation gemäss Fig. 4,
- Fig. 7: Details der Abluft- und Trockenstation gemäss Fig. 4 in teilweise geschnittener Aufsicht,
- Fig. 8: ein Längsschnitt der Abluft- und Trockenstation gemäss Fig. 4 und
- Fig. 9 bis 12: vier Schnitte durch die Tragelemente gemäss den Schnittlinien IX, X bzw. XI in Fig. 7.

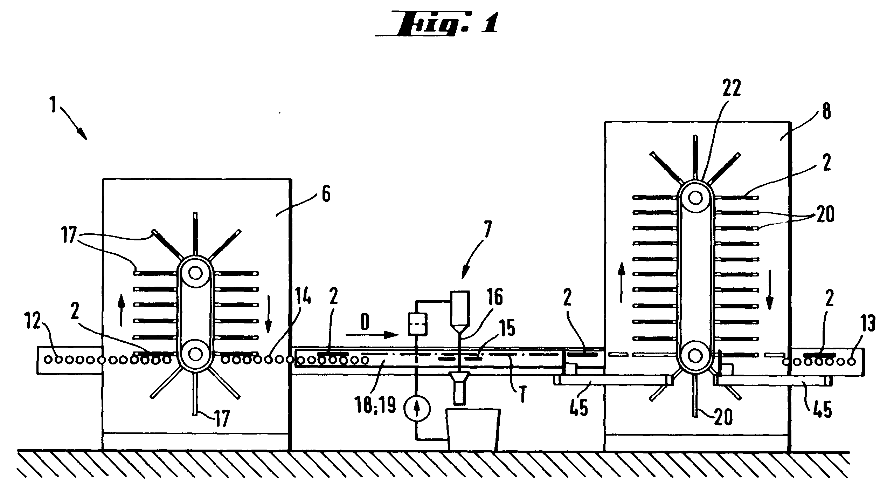

Eine Leiterplattenbeschichtungsanlage, die in den Fig. 1 bis 3 in drei Ausführungbeispielen dargestellt ist, ist jeweils gesamthaft mit 1 bezeichnet. Die drei Ausführungsbeispiele der erfindungsgemässen Beschichtungsanlage unterscheiden sich durch den unterschiedlichen Ausbaugrad, das heisst durch eine unterschiedliche Anzahl von Bearbeitungsstationen für zu beschichtenden Leiterplatten 2.

Die in Fig. 1 schematisch dargestellte Beschichtungsanlage 1 umfasst in der Reihenfolge ihrer Anordnung eine Vorwärmstation 6, eine Beschichtungsstation 7 und eine Abluft- und Trockenstation 8, die in Durchlaufrichtung D nacheinander von den Leiterplatten 2 durchlaufen werden. Eine Eingaberollenbahn 12 und eine Übergaberollenbahn 14 sind eingangs bzw. ausgangs der Vorwärmstation vorgesehen. Ausgangs der Abluft und Trockenstation 8 ist eine Ausgaberollenbahn 13 angeordnet, über die die Leiterplatten 2 weiteren Bearbeitungsanlagen zugeführt werden können. In den einzelnen Stationen werden die Leiterplatten von Transportmitteln 17, 18 und 20 übernommen und durch die jeweilige Station transportiert und an die in Transportrichtung D der Leiterplatten 2 folgende Bearbeitungsstation übergeben.

Die Beschichtungsstation 7 umfasst einen Giesstisch 15 mit einem Giesskopf. Der Giesskopf ist dabei derart ausgebildet, dass vorzugsweise UV-härtbarer Kunststoff C, Lack oder dergleichen, der zum Giesskopf gepumpt wird, einen frei fallenden Giessvorhang 16 bildet, unter dem die zu beschichtenden Oberflächen der Leiterplatten 2 hindurchtransportiert werden. Die seitliche Ausdehnung des Giessvorhangs 16, quer zur Transportrichtung D der Leiterplatten 2, wird dabei durch Giessmesser begrenzt. Ein derartiger Giesskopf ist beispielsweise in der US-A4,559,896 beschrieben.

Durch die Giessmesser ist sichergestellt, dass ein schmaler Rand entlang der Längsseiten der Leiterplatten 2 frei von der Beschichtung C bleibt. Die Transportmittel 18 für die Leiterplatten 2 in der Beschichtungsstation 7 umfassen seitliche Führungsmittel 19 für die Längsränder der Leiterplatten. Vorzugsweise sind diese durch zwei seitlich angeordnete Transportbänder gebildet, welche jeweils in Transportrichtung D der Leiterplatten 2 um einen zugehörigen Richtholm herumlaufen. Die Richtholme sind auf die Breite der Leiterplatten automatisch, vorzugsweise elektro-pneumatisch einstellbar. Auf diese weise werden die Leiterplatten 2 ausgerichtet, sodass ihre Längskanten etwa parallel zur Transportrichtung D verlaufen. Die Transportbänder greifen die Längskanten der Leiterplatten 2 und transportieren sie zur Beschichtung unter dem frei fallenden Giessvorhang 16 hindurch. Dabei sorgt die seitlich den Giessvorhang begrenzenden Giessmesser dafür, dass die Transportbänder nicht verschmutzt werden. Eine derartige Beschichtungsstation mit allen ihren Einzelheiten ist beispielsweise in der EP-A-0,542,684 beschrieben, die nach dem Prioritätstag der vorliegenden Erfindung veröffentlicht ist. Die Beschichtungsanlage 1 gemäss Fig. 1 ist für die Beschichtung nur einer Oberfläche der Leiterplatten 2 ausgelegt und umfasst nur die unbedingt erforderliche Grundausstattung.

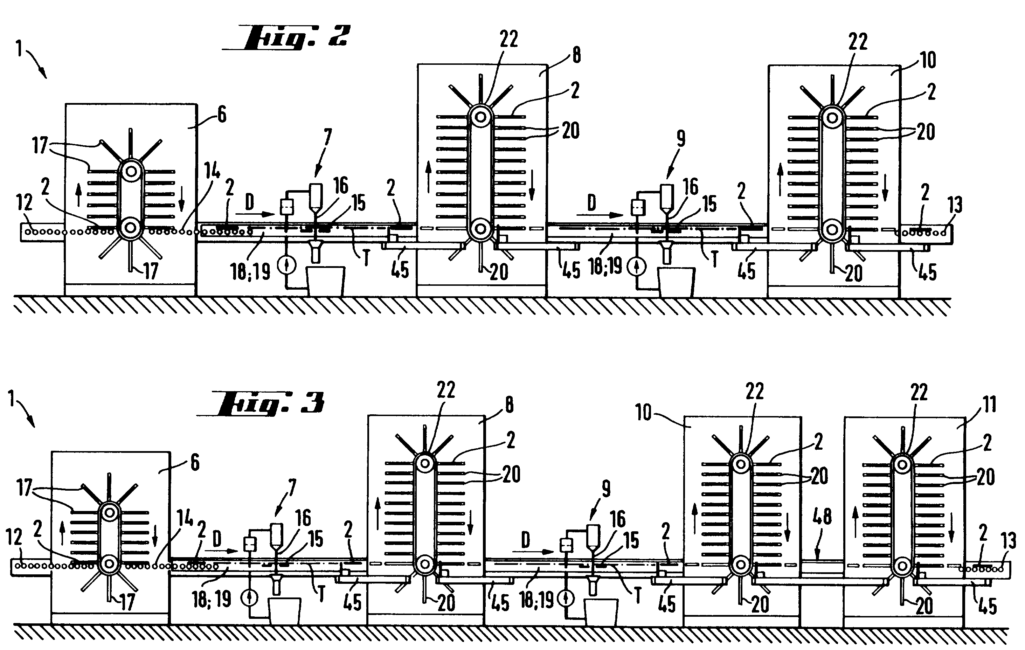

Die in den Fig. 2 und 3 dargestellten Ausführungsbeispiele der erfindungsgemässen Beschichtungsanlage 1 sind für ein beidseitiges Beschichten der Leiterplatten 2 geeignet. Gemäss den schematischen Darstellungen sind sie gegenüber dem ersten Ausführungsbeispiel nach Fig. 1 um eine zweite Beschichtungsstation 9 und um eine zusätzliche Abluft- und Trockenstation 10 (Fig. 2) bzw. um zwei derartige Abluft- und Trockenstationen 10 und 11 (Fig. 3) erweitert. In der ersten Abluft- und Trockenstation 8 werden die einseitig beschichteten Leiterplatten 2 soweit getrocknet, dass sie ohne Gefahr einer Verletzung der Beschichtung C gewendet werden können. Ausgangs der ersten Abluft und Trockenstation 8 werden die Leiterplatten 2 an die zweite Beschichtungsstation 9 übergeben. Der Aufbau der zweiten Beschichtungsanlage 9 entspricht dem der ersten Beschichtungsanlage. Nach der Beschichtung der zweiten Oberfläche werden die Leiterplatten an die zweite Abluft- und Trockenstation 10 übergeben. Diese entspricht der ersten Abluft- und Trockenstation 8. Je nach der Durchlaufgeschwindigkeit der Leiterplatten 2 durch die zweite Abluft- und Trockenstation 10 sind die Platten ausgangs der Station vollständig durchgetrocknet und werden über die Ausgaberollenbahn 13 aus der Beschichtungsanlage 1 ausgefahren (Fig. 2). Bei Beschichtungsanlagen 1, die einen höheren Durchsatz an Leiterplatten 2 haben, ist im Anschluss an die zweite Abluft- und Trockenstation 10 noch eine dritte Abluft- und Trockenstation 11 vorgesehen, deren Aufbau gleichfalls der der ersten 7 entspricht (Fig. 3). Zwischen der zweiten und der dritten Abluft- und Trockenstation 10 und 11 sind Transportmittel 48 vorgesehen, mit Hilfe welcher die Leiterplatten von einer Station zur nächsten transportiert werden. Vorzugsweise umfassen diese Transportmittel 48 analog zu den Transportmitteln 18 in den Beschichtungsstationen 7 bzw. 9 seitliche Führungsmittel 19 für die Längsränder der Leiterplatten. Diese sind durch zwei seitlich angeordnete Transportbänder gebildet, welche jeweils in Transportrichtung D der Leiterplatten 2 um einen zugehörigen Richtholm herumlaufen. Die Richtholme sind auf die Breite der Leiterplatten automatisch, vorzugsweise elektro-pneumatisch einstellbar. Auf diese Weise werden die Leiterplatten 2 ausgerichtet, sodass ihre Längskanten etwa parallel zur Transportrichtung D verlaufen. Die Transportbänder greifen die Längskanten der aus der zweiten Abluft- und Trockenstation 10 kommenden Leiterplatten 2 und transportieren sie zur dritten Abluft- und Trockenstation 11 weiter. Die Vorwärmstation 6 und die Abluft und Trockenstationen 8, 10 bzw. 11 sind vorzugsweise durch vertikale Umlauföfen gebildet, bei denen die Leiterplatten während der Wärmebehandlung gleichzeitig gewendet werden.

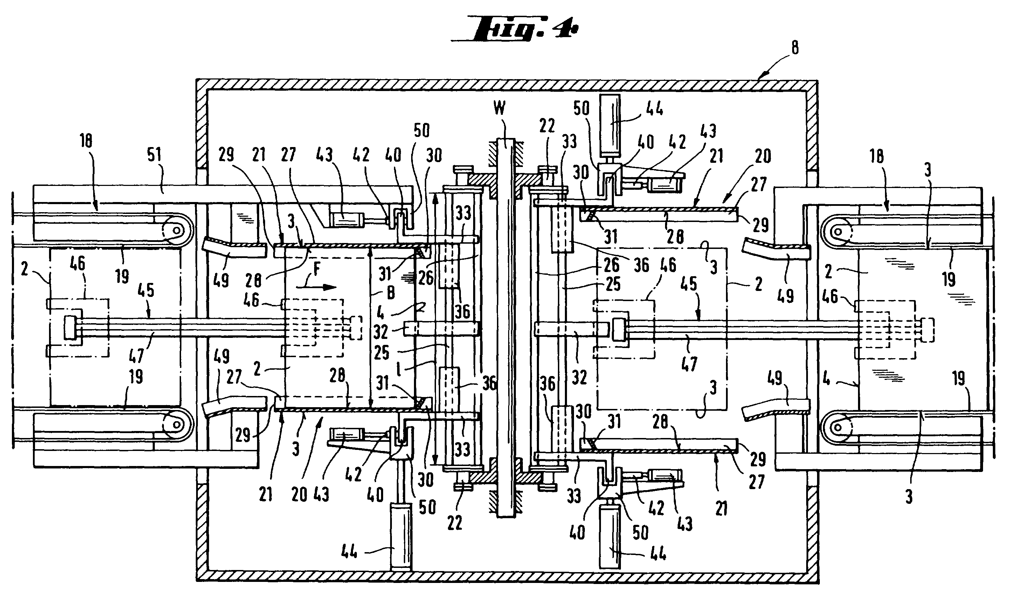

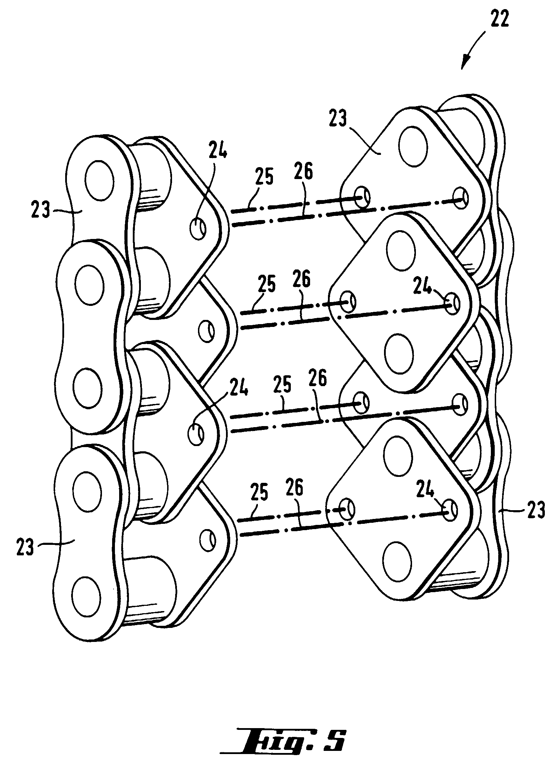

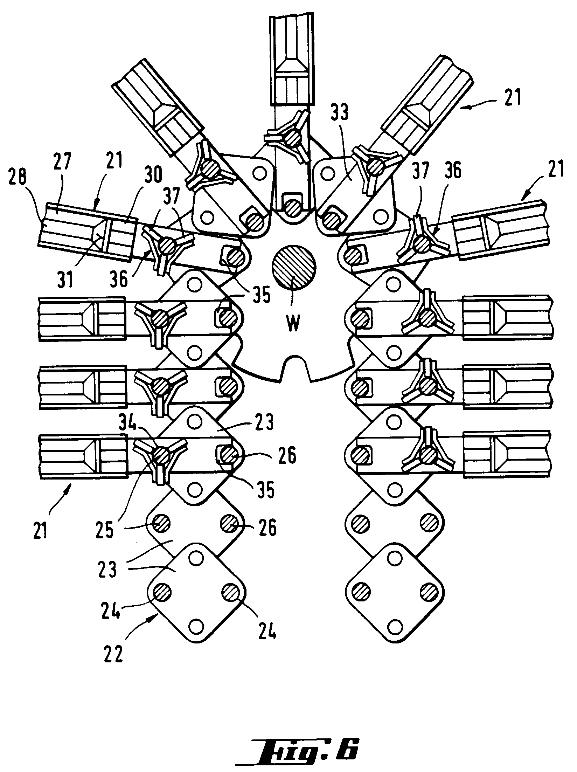

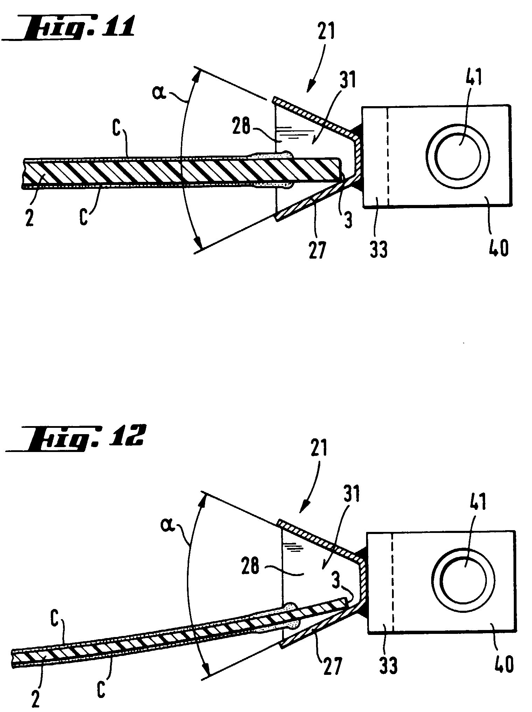

In den Fig. 4 bis 12 ist ein Ausführungsbeispiel einer Abluft- und Trockenstation 8 bzw. 10 oder 11 in diversen Schnitten und Detaildarstellungen gezeigt. Wie in den Fig. 1 bis 3 schematisch angedeutet und in den Fig. 4, 6 und 8 in grösserem Detail dargestellt, ist die Station mit einer Reihe von Tragelementen 20 für die Leiterplatten 2 ausgestattet. Insbesondere sind diese Tragelemente 20 auf die Breite B der eingeschobenen Leiterplatten 2 einstellbar. Die Tragelemente 20 umfassen jeweils zwei Tragarme 21, die sich etwa parallel zu den Längsrändern 3 einer eingeschobenen Leiterplatte 2 erstrecken. Wenigstens einer der Tragarme 21, gemäss dem in Fig. 4 dargestellten Ausführungsbeispiel beide Tragarme sind quer zu ihrer Längserstreckung verschiebbar. Jedes Tragelement 20 ist an zwei einander gegenüberliegenden vorzugsweise vertikal endlos umlaufenden Rollenketten 22 befestigt (Fig. 5 und 6), die von einer Antriebswelle W angetrieben werden. Die Rollenketten weisen Kettenglieder 23 auf welche mit zwei Bohrungen 24 versehen sind. Zwei Führungstangen 25 und 26 sind in die zwei Bohrungen 24 jedes Kettengliedes 23 gesteckt und verbinden die beiden endlos umlaufenden Rollenketten. Die Tragarme 21 der Tragelemente 20 sind jeweils paarweise auf den die beiden Ketten 22 verbindenden Führungstangen gegeneinander verschiebbar (Fig. 4).

Gemäss Fig. 4 umfasst jeder Tragarm 21 eine Führungsschiene 27 mit einer Längsnut 28, die ein etwa V-förmiges Profil besitzt und einen Öffnungswinkel α von etwa 30° bis 50°, vorzugsweise etwa 40° aufweist. Die Führungsschiene 27 ist an ihrem der Kette 22 abgewandten Ende 29 offen ausgebildet, sodass der Längsrand 3 einer Leiterplatte 2 eingeschoben werden kann. Am der Kette 22 zugewandten Stirnende 30 ist in der Längsnut 28 ein Anschlag 31 für den Querrand 4 einer eingeschobenen Leiterplatte vorgesehen. Die Führungsschienen 27 jedes Paares von Tragarmen 21 sind derart angeordnet, dass ihre Längsnute 28 einander zugekehrt sind und etwa parallel zu den Längskanten 3 der einzuschiebenden Leiterplatten 2 verlaufen.

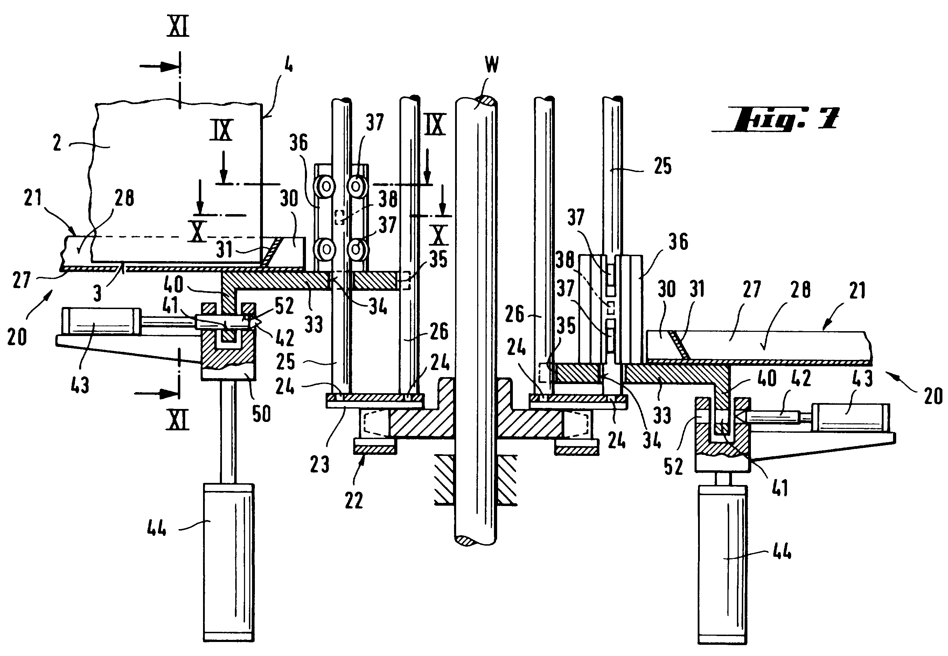

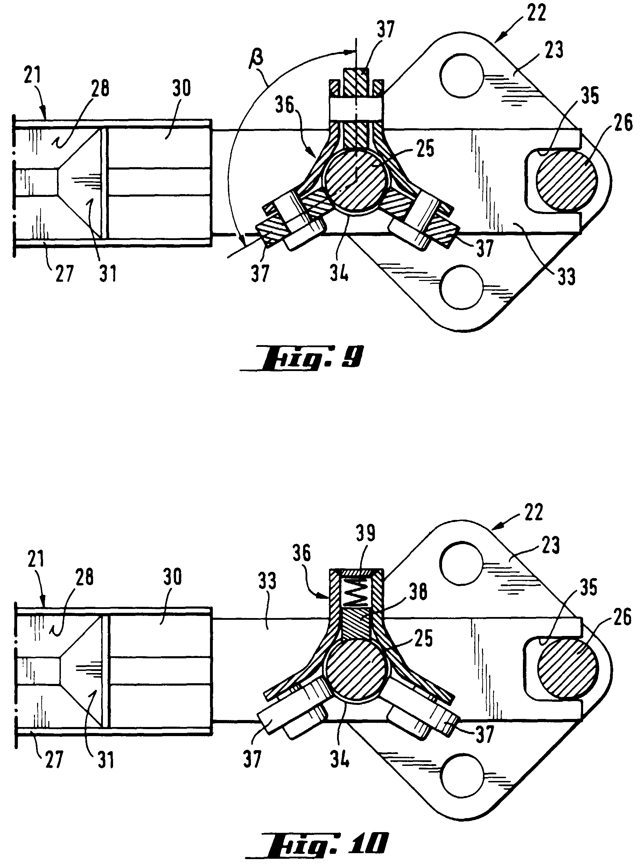

Die Führungsschienen 27 sind auf Halterungen 33 montiert (Fig. 7) die mit einer Bohrung 34 zur Aufnahme der in Einschubrichtung F der Leiterplatten 2 in die Tragelemente 20 vorderen Führungstange 25 ausgestattet ist. Dabei ist festzuhalten, dass die Einschubrichtung F der Leiterplatten 2 in die Tragelemente 20 der Abluft- und Trockenvorrichtung identisch ist mit der im wesentlichen horizontalen Transportrichtung D der Leiterplatten 2. An ihrem hinteren Ende weisen die Halterungen 33 gabelartige Führungen 35 auf, welche jeweils die hintere Führungsstange 26 umgreifen (Fig. 9 und 10). Dieses konstruktive Merkmal hat den Vorteil, dass an den Umlenkpunkten der endlos umlaufenden Rollenketten 22 keine Zugspannungen an den hinteren Führungsstangen 26 bzw. an den Halterungen 33 auftreten.

Gemäss den Darstellungen in Fig. 7 und in den Fig. 9 und 10 ist jede Halterung 33 im Bereich der Bohrung 35 mit einem Laufwagen 36 ausgestattet. Jeder Laufwagen 36 ist mit Rollen 37 ausgestattet, die derart entlang des Umfangs der vorderen Fübrungsstange 25 und hintereinander angeordnet sind, dass die Halterung 33 und mit ihr die Führungsschiene 27 verkantungsfrei entlang der vorderen Führungsstange 25 verschiebbar ist. Vorzugsweise umfasst der Laufwagen 36 sechs Rollen 37, die in zwei Trippeln über die Länge des Laufwagens verteilt sind. Dabei sind die Rollen 37 jedes Rollentrippels jeweils um einen Winkel β von etwa 120° gegeneinander versetzt, sodass die Rollen die Führungsstange 25 in etwa um denselben Winkel gegeneinander versetzten Bereichen berühren. Gemäss der Darstellung in Fig. 10 weist jeder Laufwagen 36 eine Bremse, die durch einen Bremsklotz 38 gebildet ist, der durch eine Feder 39 gegen die vordere Führungsstange 25 gedrückt wird.

Die Breitenverstellung der Tragelemente 20 erfolgt durch ein vorzugsweise pneumatisches Verschieben wenigstens eines der beiden Tragarme 21 jedes Tragelementes 20. In Fig. 4 sind zwei Ausführungsbeispiele dieser Verstellelemente dargestellt. Dabei sind zur Verstellung des in Einschubrichtung der Leiterplatten 2 linken Tragarms 21 mechanische Stellmittel dargestellt. Für den rechten Tragarm 21 sind pneumatische Stellmittel angedeutet. Es versteht sich, dass jeweils für die Verstellung beider Tragarme 21 nur entweder die einen - mechanischen - oder die anderen - pneumatischen - Stellmittel vorgesehen sind. Beiden Verstellmitteln ist gemeinsam, dass an jeder Halterung 33 ein Anschlag 40, Fortsatz oder dergleichen angeordnet ist, der sich, wie in Fig. 4 und 7 dargestellt, etwa parallel zu der Längserstreckung der Führungsstangen 25, 26 nach aussen erstreckt. Im Falle der Verstellmittel für den rechten Tragarm 21 ist der Anschlag 40 mit einem Stössel 50 von pneumatischen Querverstellmitteln 44 für die Tragarme 21 koppelbar. Bei den mechanischen Verstellmitteln erstreckt sich jeweils ein Stellarm 51 von den Richtholmen der Führungsmittel 18 für die Leiterplatten in der Beschichtungsstation 7 parallel zur Plattentransportrichtung D in Richtung des Eingangs der Abluft- und Trockenstation 8. Die Stellarme 51 sind zusammen mit den Richtholmen auf die Breite B der transportierten Leiterplatten 2 einstellbar. Eingangs der Abluft- und Trockenstation 8 ist am Ende des Stellarms 51 ein Stössel 50 vorgesehen, der mit dem Anschlag 40 koppelbar ist. Um die Tragarme 21 nicht nur aufeinander zu verstellen zu können, sondern um sie auch wieder auseinanderstellen zu können, ist der Anschlag 40 mit einer Bohrung 41 ausgestattet (Fig. 7 und 11 bzw. 12). Entsprechend weist auch der Stössel 50 der pneumatischen Querverstellmittel 44 bzw. der Stössel am Ende des Stellarms 51 eine Bohrung 52 auf. Ein von einem vorzugsweise pneumatischen Antrieb 43 betätigbarer Arretierstift 42 ist durch die Bohrungen 41 und 52 einschiebbar. Im Falle der pneumatischen Verstellmittel ist der Antrieb 43 mit den Querverstellmitteln 44 verbunden. Bei den mechanischen Verstellmitteln ist der Antrieb am Stellarm 51 befestigt und mit diesem verstellbar. Auf diese Weise sind der Stössel 50 und der Anschlag 40 miteinander verriegelbar, und der Tragarm 21 kann wieder nach aussen gezogen werden, um die Breite des Tragelements wieder zu vergrössern. Auf diese Weise sind die Querverstellmittel mit den Verstellmitteln für die Breitenverstellung der seitlichen Führungsmittel 19 in der Beschichtungsstation mechanisch gekoppelt oder können sie steuerungsmässig gekoppelt werden, sodass die Breitenverstellung der Tragelemente 20 in Abhängigkeit von der Breitenverstellung der seitlichen Führungsmittel erfolgt.

Vorzugsweise erstreckt sich von den Führungsstangen 25, 26 weg ein Abstützorgan 32 für den vorlaufenden Querrand 4 einer eingeschobenen Leiterplatte. Dieses Abstützorgan 32 erstreckt sich unterhalb der Einschubebene, die durch die Transportebene T der Leiterplatten in der Beschichtungsstation definiert ist, bis etwa zu einem Bereich, der etwa der gedachten Verbindunglinie der hinteren stirnseitigen Anschlage 31 in den Längsnuten der Führungschienen 27 eines Tragarrnpaares 21 entspricht. Das Abstützorgan ist in einem Bereich, der sich ab etwa dem ersten Viertel bis etwa über das dritte Viertel der Länge 1 der Führungsstangen 25, 26 erstreckt und sich vorzugsweise etwa im Bereich der halben Länge 1 der Führungsstangen 25, 26 befindet, am Umfang der Führungsstangen 25, 26 befestigt. Auf diese Weise angeordnet reicht das Abstützorgan 32 bis zum vorlaufenden Querrand 4 der eingeschobenen Leiterplatte und unterstützt deren Unterseite derart, dass auch dünne Platten nicht durchhängen.

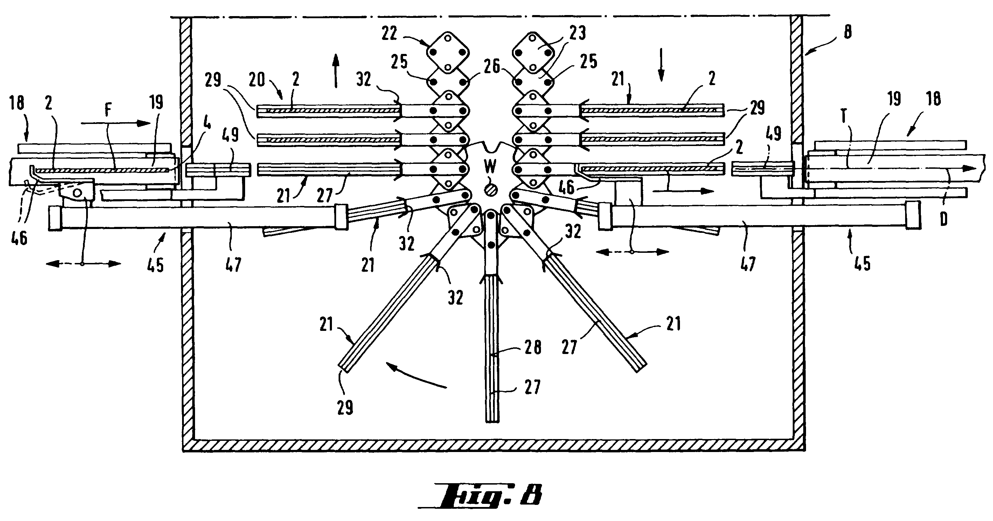

Wie in den Fig. 1 bis 3 angedeutet und in den Fig. 4 und 8 in Detail dargestellt sind eingangs und ausgangs der Abluft- und Trockenstation gerätefeste Vorschubmittel 45 für die Leiterplatten 2 vorgesehen, mit deren Hilfe die Leiterplatten 2 von den Transportmitteln der vorhergehenden Bearbeitungsstation übernommen werden und in die Tragelemente 20 eingeschoben werden können bzw. nach dem Wenden der Leiterplatten 2 wieder aus den Tragelementen 20 ausgeschoben werden können. Diese Vorschubmittel 45 sind unterhalb der horizontalen Transportebene T der Leiterplatten 2 angeordnet. Sie umfassen ein Schiebeelement 46, das am bezogen auf die Transportrichtung D hinteren Querrand 4 der Leiterplatten 2 angreift. Ein vorzugsweise pneumatischer Antrieb 47 erlaubt die Verstellung des Schiebeelements 46 in oder entgegen der Transportrichtung D der Leiterplatten 2. Wie in Fig. 4 und 8 auch noch dargestellt, können eingangs und ausgangs der Abluft- und Trockenstation auch noch Führungsrinnen 49 für die Leiterplatten 2 vorgesehen sein. Diese sind vorzugsweise mit den seitlichen Führungselementen 18 der Beschichtungsstationen verbunden. Vorzugsweise sind es kurze V-förmige Führungsschienen, die jeweils eingangsseitig leicht nach aussen gekrümmt verlaufen, um einer ankommenden Platte eine etwa trichterförmige Einlaufstrecke darzubieten.

Zur Beschichtung werden die Leiterplatten 2 in der Vorwärmstation 6 erwärmt. In der Vorwärmstation 6 sind keine speziellen Tragelemente 17 erforderlich, die die Leiterplatten nur an den Längsrändern ergreifen, da die Platten ja noch nicht beschichtet sind. Die Platten können daher beispielsweise in Tragelementen mit von zwei Holmen abstehenden horizontalen Zinken transportiert werden. Beim Wenden kippen die Platten einfach auf die Rückseite des vorlaufenden Tragelements 17 werden so nach unten transportiert und auf die Übergaberollenbahn 14 abgelegt. Von der Übergaberollenbahn 14 gelangen die Leiterplatten zur ersten Beschichtungsstation 7. In dieser werden sie von den seitlichen Führungsmitteln 18 an ihren Längsrändern 3 ergriffen, ausgerichtet und unter dem Giessvorhang 16 hindurchtransportiert. Dabei werden sie stets an ihren Längsrändern 3 geführt. Ausgangs der ersten Beschichtungsstation 7 gelangen die Leiterplatten 2 in den Einzugsbereich der Vorschubmittel 45, welche die nunmehr einseitig beschichteten Leiterplatten 2 in die bereits in Abhängigkeit von der Breitenverstellung der seitlichen Führungsmittel 18 in der ersten Beschichtungsstation 7 bezüglich ihrer Breite eingestellten Tragelemente 20 der ersten Abluft- und Trockenstation 8 einschiebt. Beim Aufwärtstransport in dem vertikalen Umlaufofen wird die beschichtete Oberfläche der Leiterplatten 2 soweit getrocknet, dass die Beschichtung C beim Wenden der Platten, wo sie ja kurzfristig vertikal stehen, nicht verrinnt oder abläuft. Nach dem Abwärtstransport der Leiterplatten werden sie ausgangs der Station von weiteren Vorschubmitteln 45 wieder aus den Tragelementen herausgezogen. Sollen die Platten nur einseitig beschichtet werden, gelangen sie auf die Ausgaberollenbahn 13, von wo sie an weiter Bearbeitungsstatinen weitertransportiert werden können.

Sollen die Platten beidseitig beschichtet werden, werden sie von den Vorschubmitteln 45 ausgangs der ersten Abluft- und Trockenstation 8 an die seitlichen Führungsmittel 18 der zweiten Beschichtungsstation 9 übergeben. Seitlich gehalten und geführt werden die Leiterplatten 2 erneut unter dem Giessvorhang 16 hindurchtransportiert und wird die zweite Oberfläche beschichtet. Dabei ist festzuhalten, dass die Leiterplatte 2 immer nur an ihren Längsrändern 3 gehalten und geführt wird. Nie kommt die bereits zuvor beschichtete Oberfläche in Berührung mit den Transportmitteln. Ausgangs der zweiten Beschichtungsstation 9 gelangen die Leiterplatten 2 in den Einzugsbereich der Vorschubmittel 45 der zweiten Abluft- und Trockenstation 10, welche die nunmehr einseitig beschichteten Leiterplatten 2 in die bereits in Abhängigkeit von der Breitenverstellung der seitlichen Führungsmittel 18 in der zweiten Beschichtungsstation 9 bezüglich ihrer Breite eingestellten Tragelemente 20 der zweiten Abluft- und Trockenstation 10 einschiebt. Beim Aufwärtstransport in dem vertikalen Umlaufofen wird die zweite beschichtete Oberfläche der Leiterplatten 2 soweit getrocknet, dass die Beschichtung C beim Wenden der Platten, wo sie ja kurzfristig vertikal stehen, nicht verrinnt oder abläuft. Die bereits vorgetrocknete erste beschichtete Oberfläche wird weiter getrocknet, so dass die Platten ausgangs der Station mit dieser Oberfläche abgelegt werden können, ohne die Beschichtung C zu verletzen. Nach dem Abwärtstransport der Leiterplatten werden sie ausgangs der Station von weiteren Vorschubmitteln 45 wieder aus den Tragelementen herausgezogen und an die Ausgaberollenbahn 13 übergeben. Falls die Durchlaufgeschwindigkeit der Leiterplatten 2 durch den Durchlauftrockner so hoch ist, dass die ausgangsseitig untere Oberfläche noch nicht ausreichend getrocknet ist, können die Leiterplatten 2 ausgangs der zweiten Abluft und Trockenstation 10 an eine weitere dritte Trockenstation 11 übergeben werden. Dazu sind Transportmittel 48 vorgesehen, welche die Leiterplatten aus den Transportelementen 20 der einen Station heraus- und in die Transportelemente 20 der folgenden Station hineinschieben. Vorzugsweise umfassen diese Transportmittel 48 Vorschubmittel 45, die gleich aufgebaut sind wie die Transportmittel eingangseitig der vorhergehenden Station. Zudem können auch noch seitliche Führungen vogesehen sein, deren gegenseitiger Abstand in Abhängigkeit von der Breite B der Leiterplatten 2 verstellbar ist. Nach dem Durchlaufen der dritten Abluft- und Trockenstation 11 sind die Oberflächen der Leiterplatten 2 ausreichend getrocknet, dass keine Beschädigung der Beschichtungen C durch liegenden Transport mehr erfolgen kann.

Bei dem erfindungsgemässen Verfahren werden die Leiterplatten 2 nur einmal, unmittelbar eingangs der ersten Beschichtungsstation ausgerichtet. Ab diesem Zeitpunkt werden die Leiterplatten 2 von den verschiedenen Transportmitteln der verschiedenen Bearbeitungstationen stets nur an den seitlichen Rändern gestützt und geführt. Auch bei der Übergabe der einseitig oder beidseitig beschichteten Leiterplatten 2 von einer Bearbeitungsstation der Beschichtungsanlage zur nächsten werden die Leiterplatten 2 im wesentlichen ständig an ihren beschichtungsfreien Längsrändern 3 geführt und unterstützt. Es erfolgt kein Klemmen oder Halten der Platten. Ein Abstützorgan unterstützt den vorlaufenden Querrand 4 der Leiterplatten 2 während der Wärmebehandlung, sodass auch für dünne Leiterplatten 2 ein verletzungsfreier Transport durch die Abluft- und Trockenstation(en) gewährleistet ist. Nur die unbeschichtete Oberfläche einer Leiterplatte 2 oder die ausreichend getrocknete Beschichtung C der Leiterplatten kommt in Berührung mit Rollenbahnen, Förderbändern oder dergleichen. Die Beschichtungsanlage ist kompakt in ihrem Aufbau, auf platzaufwendige Rollenbahnen an den Schnittstellen zwischen den Beschichtungsstationen und den Abluft- und Trockenstationen und zwischen hintereinandergeschalteten Trockenstationen kann verzichtet werden.

## Patentansprüche

1. Verfahren zur Beschichtung von plattenförmigem Gut, insbesondere von Leiterplatten (2), bei dem das plattenförmige Gut (2) durch mehrere aufeinanderfolgende Bearbeitungsstationen (6-8; 6-10; 6-11) einer Beschichtungsanlage (1) transportiert wird, in denen es vorgewärmt, mit vorzugsweise UV-härtbarem Kunststoff (C) oder Lack zumindest einseitig nass beschichtet und nach dem Beschichten einer Seite jeweils abgelüftet und getrocknet wird, dadurch gekennzeichnet, dass das plattenförmige Gut (2) jeweils nach der Beschichtung an Tragelemente (20) einer Abluft- und Trockenstation (8;10) übergeben wird, die gerätefest mit ihr verbunden sind, dass dabei die Breite der Tragelemente (20) auf die Breite (B) des zu transportierenden Guts (2) eingestellt wird, und dass das plattenförmige Gut (2) mindestens ab der ersten Beschichtung über seine gesamte Länge an den Längsrändern (3) unterstützt und geführt wird.

2. Verfahren nach Anspruch 1, dadurch gekennzeichnet, dass das plattenförmige Gut (2) in Längsnuten (28) zweier etwa parallel zu den Längskanten (3) des Guts (2) verlaufende Tragarme (21) eingschoben wird, und dass die Breitenverstellung der Tragelemente (20) durch Verstellen wenigstens eines der Tragarme (21) quer zur Einschubrichtung des Guts (2) erfolgt.

3. Verfahren nach Anspruch 2, dadurch gekennzeichnet, dass die Verstellbewegung des bzw. der Tragarme (21) der Tragelemente (20) gebremst wird.

4. Verfahren nach einem der vorangehenden Ansprüche, dadurch gekennzeichnet, dass die Beschichtung in einer Beschichtungsstation (7;9) erfolgt, welche mit seitlichen Führungsmitteln (19) für die Längsränder (3) ausgestattet ist, die jeweils automatisch auf die Breite (B) eines zu beschichtenden Guts (2) eingestellt werden, und dass die Breitenverstellung der Tragelemente (20) der Abluft- und Trockenstation (8;10) in Abhängigkeit von der Breitenverstellung der seitlichen Führungsmittel (19) für die Längsränder (3) in der Beschichtungsstation (7;9) erfolgt.

5. Verfahren nach Anspruch 4, dadurch gekennzeichnet, dass das plattenförmige Gut (2) mit Hilfe von eingangsseitig gerätefest mit der Abluft- und Trockenstation (8; 10) verbundenen und vorzugsweise pneumatisch betätigbaren Eingabemitteln (45) aus den seitlichen Führungen (19) der Beschichtungsstation (7;9) in die Tragelemente (20) der Abluft- und Trockenstation (8;10) eingeschoben wird.

6. Verfahren nach Anspruch 5, dadurch gekennzeichnet, dass das plattenförmige Gut (2) in einer ersten Abluft- und Trockenstation (8) gewendet wird, an eine zweite Beschichtunganlage (9) zur Beschichtung der zweiten Seite mit vorzugsweise UV-härtbarem Kunststoff (C) oder Lack übergeben wird und im Anschluss daran zu wenigstens einer weiteren zweiten Abluft und Trockenstation (10) weitertransportiert wird.

7. Verfahren nach Anspruch 6, dadurch gekennzeichnet, dass das plattenförmige Gut (2) während seines Transportes von der ersten Beschichtstation (7) bis zum Ausgang einer abschliessenden Abluft- und Trockenstation (8;10;11) der Beschichtungsanlage (1) und während seiner Übergabe an die verschiedenen Transportmittel (17-20) der einzelnen Bearbeitungsstationen im wesentlichen ständig an den Längsrändern (3) geführt oder gestützt wird.

8. Verfahren nach Anspruch 7, dadurch gekennzeichnet, dass das plattenförmige Gut (2) bei der Übergabe von den Tragelementen (17) einer Vorwärmstation (6), die eingangs der Beschichtungsanlage (1) angeordnet ist, an die Transportmittel (19) der ersten Beschichtungstation (7) zentriert wird, und dass das plattenförmige Gut ab dieser ersten Zentrierung im wesentlichen ständig an den Längsrändern (3) gestützt oder geführt wird, und derart bis zum Ausgang der Beschichtungsanlage in ausgerichteter Position transportiert wird.

9. Verfahren nach einem der vorangehenden Ansprüche, dadurch gekennzeichnet, dass der Transport derart erfolgt, dass im wesentlichen nur die lackfreien Längsränder (3) mit den Transportmitteln (17-20) in den einzelnen Bearbeitungstationen in Berührung kommen.

10. Verfahren nach einem der vorangehenden Ansprüche, dadurch gekennzeichnet, dass das plattenförmige Gut beim Transport durch die Abluft- und Trocknungsstation(en) (8;10;11) und gegebenenfalls beim Transport durch eine eingangs der ersten Beschichtungsanlage (7) vorgesehene Vorwärmstation (6) an einem seiner Querränder (4), vorzugsweise in einem Bereich, der sich etwa ab dem ersten Viertel bis über etwa das dritte Viertel des Guts (B) erstreckt, insbesondere etwa im Bereich der halben Breite (B), an wenigstens einem Punkt gestützt wird.

11. Verfahren nach einem der vorangehenden Ansprüche, dadurch gekennzeichnet, dass die Breite der Tragelemente (20) elektro-pneumatisch eingestellt wird.

12. Vorrichtung zur Beschichtung von plattenförmigem Gut, insbesondere von Leiterplatten (2), umfasssend eine eingangsseitig der Vorrichtung angeordnete Vorwärmstation (6) für das plattenförmige Gut (2) und daran anschliessend in der Reihenfolge ihrer Anordnung wenigstens eine Beschichtungsstation (7) zur Beschichtung wenigstens einer Seite des Guts (2) mit vorzugsweise UV-härtbarem Kunststoff (C) oder Lack und wenigstens eine Abluft- und Trockenstation (8), welche Bearbeitungsstationen jeweils Transportmittel (17-20) für das Gut (2) aufweisen, dadurch gekennzeichnet, dass die Transportmittel (20) in der Abluft- und Tockenstation (8) Tragelemente für die Längsränder (3) des Guts (2) umfassen, deren Breite auf die Breite (B) des zu tragenden Guts (2) einstellbar ist und welche es (2) über seine gesamte Länge an den Längsrändern (3) unterstützen und führen, und dass die Transportmittel (18), welche das plattenförmige Gut (2) zum Eingang der Abluft- und Trockenstation (8) transportieren, das plattenförmige Gut (2) über seine gesamte Länge an den Längsrändern (3) unterstützen und führen.

13. Vorrichtung nach Anspruch 12, dadurch gekennzeichnet, dass jedes Tragelement (20) zwei etwa parallel zu den Plattenlängsrändern (3) verlaufende Tragarme (21) umfasst, und dass wenigstens einer der Tragarme (21) quer zur Längserstreckung der Tragarme (21) verschiebbar ist.

14. Vorrichtung nach Anspruch 13, dadurch gekennzeichnet, dass jedes Tragelement (20) an zwei einander gegenüberliegenden vorzugsweise vertikal endlos umlaufenden Rollenketten (22) befestigt ist, deren Kettenglieder 23) jeweils mit Bohrungen (24) zur Aufnahme von vorzugsweise zwei Führungstangen (25,26) von etwa kreisförmigem Querschnitt versehen sind, entlang derer die Tragarme (21) quer zu ihrer Längserstreckung verschiebbar sind.

15. Vorrichtung nach Anspruch 14, dadurch gekennzeichnet, dass der Tragarm (21) jedes Tragarmpaares eine Führungsschiene (27) mit einer Längsnut (28) von etwa V-förmigem Profil umfasst, die an ihrem der Kette (22) abgewandten freien Ende stirnseitig offen ausgebildet ist und an ihrem anderen Stirnende einen Anschlag (31) für den Querrand (4) eines eingeschobenen Guts (2) aufweist, und dass die Führungsschienen (27) jedes Tragarmpaares derart angeordnet sind, dass ihre Längsnute (28) zueinander parallel verlaufen und einander zugekehrt sind.

16. Vorrichtung nach Anspruch 15, dadurch gekennzeichnet, dass der Öffnungswinkel (α) der Längsnut von etwa 30° - 50°, vorzugsweise etwa 40° beträgt.

17. Vorrichtung nach Anspruch 15 oder 16, dadurch gekennzeichnet, dass sich von den Führungstangen (25,26) weg ein Abstützorgan (32) für den vorderen Querrand (4) des eingeschobenen Guts (2) erstreckt, welches Führungsorgan (32) in einem Bereich, der sich ab etwa dem ersten Viertel bis etwa über das dritte Viertel der Länge der Führungsstangen (25,26) erstreckt und sich vorzugsweise etwa im Bereich der halben Länge der Führungsstange befindet, am Umfang der Führungstangen befestigt ist und sich unterhalb der Einschubebene (T) des Guts (2) etwa bis zum hinteren stirnseitigen Anschlag (31) in der Längsnut (28) der Führungsschiene (27) erstreckt.

18. Vorrichtung nach einem der Ansprüche 15 - 17, dadurch gekennzeichnet, dass jede Führungsschiene (27) auf einer Halterung (33) befestigt ist, die mit einer Bohrung (34) zur Aufnahme der in Transportrichtung (D) des Guts (2) vorderen Führungsstange (25) ausgestattet ist, und die an ihrem hinteren Ende eine gabelartige Führung (35) aufweist, welche die zweite hintere Führungsstange (26) umgreift.

19. Vorrichtung nach Anspruch 18, dadurch gekennzeichnet, dass die Halterung (33) im Bereich der Bohrung (34) mit einem Laufwagen (36) ausgestattet ist, der eine Anzahl von Rollen (37) aufweist, die derart entlang des Umfangs der vorderen Führungstange (25) und hintereinander angeordnet sind, dass die Halterung (33) verkantungsfrei entlang der vorderen Führungsstange (25) verschiebbar ist.

20. Vorrichtung nach Anspruch 19, dadurch gekennzeichnet, dass der Laufwagen (36) sechs Rollen (37) aufweist, die jeweils trippelweise hintereinander angeordnet sind, und dass die Berührungsbereiche der einzelnen Rollen (37) jedes Rollentrippels mit der ersten Führungstange (25) um einen Winkel (β) von etwa etwa 120° gegeneinander versetzt sind.

21. Vorrichtung nach Anspruch 19 oder 20, dadurch gekennzeichnet, dass der Laufwagen (36) eine Bremse (38,39) aufweist, welche vorzugsweise als federbelasteter Bremsklotz , der gegen die vordere Führungstange drückt, ausgebildet ist.

22. Vorrichtung nach einem der Ansprüche 18 - 21, dadurch gekennzeichnet, dass die Halterung (33) einen Anschlag (40), einen Fortsatz oder dergleichen aufweist, welcher mit vorzugsweise pneumatischen Verstellmitteln (44) für die Querverstellung des Tragarms (21) koppelbar und vorzugsweise lösbar verriegelbar ist.

23. Vorrichtung nach einem der Ansprüche 12 bis 22, dass wenigstens eingangs der Abluft- und Trockenstation(en) (8;10;11) gerätefeste Vorschubmittel (45) vorgesehen sind, mit Hilfe derer des Gut (2) in die Tragelemente (20) einschiebbar ist.

24. Vorrichtung nach Anspruch 23, dadurch gekennzeichnet, dass die Vorschubmittel (45) unterhalb der Transportebene (T) angeordnet sind, und ein vorzugsweise pneumatisch in oder entgegen der Transportrichtung (D) verstellbares Schiebeelement (46) umfassen, welches am hinteren Querrand (4) des Guts (2) angreift.

25. Vorrichtung nach einem der Ansprüche 12 - 24, dadurch gekennzeichnet, dass die Transportmittel (19) in jeder Beschichtungsstation (7;9) seitliche Führungsmittel (19) für die Längsränder (3) umfassen, die mit vorzugsweise elektro-pneumatischen Verstellmitteln jeweils automatisch auf die Breite (B) einstellbar sind, wodurch das Gut (2) hinsichtlich seiner Ausrichtung auf den Giessvorhang in der Beschichtungsstation (7;9) zentrierbar ist, und dass die Verstellmittel für die Breitenverstellung der Tragelemente (20) der Abluft- und Trockenstation(en) (8;10) und die Verstellmittel für die Breitenverstellung der seitlichen Führungsmittel (19) für die Längsränder (3) in der jeweiligen Beschichtungsstation (7;9) miteinander gekoppelt sind.

26. Vorrichtung nach Anspruch 25, dadurch gekennzeichnet, dass die Transportmittel (17-20) aller Bearbeitungsstationen (6-11) der Beschichtungsanlage (1) Tragelemente oder Führungsmittel für die Längsränder (3) umfassen, deren Breite automatisch auf die Breite (B) des Guts (2) einstellbar ist, und dass an den Schnittstellen zwischen den einzelnen Bearbeitungsstationen Übergabeeinrichtungen vorgesehen sind, welche gerätefest mit der vorlaufenden oder mit der folgenden Bearbeitungsstation verbunden sind, und mit Hilfe welcher das Gut (2) nach dem Durchlauf durch die vorlaufende Bearbeitungsstation an die darauf folgende Bearbeitungsstation übergebbar ist, wobei es im wesentlichen ständig an seinen Längsrändern (3) gestützt oder geführt wird.

27. Vorrichtung nach einem der Ansprüche 12 - 26, dadurch gekennzeichnet, dass sie zur beidseitigen Beschichtung ausgebildet ist, wobei das Gut in der Vorwärmstation (6) und in den Abluft- und Trockenstationen (8;10;11) jeweils gewendet wird.

## Claims

1. A method of coating a board-shaped article, especially a printed circuit board (2), in which the board-shaped article (2) is transported through several consecutive processing stations (6-8; 6-10; 6-11) of a coating installation (1), in which stations it is preheated, wet-coated at least on one side with preferably UV-hardenable plastics (C) or lacquer, and in each case after a side has been coated it is subjected to vapour-removal and dried, wherein, after being coated, the board-shaped article (2) is transferred to carrying elements (20) of a vapour-removal and drying station (8;10), which elements are fixedly associated with the station, wherein the width of the carrying elements (20) is thereupon adjusted to the width (B) of the article (2) to be transported, and wherein the board-shaped article (2) is supported and guided, at least after the first coating, over its entire length at the longitudinal edges (3).

2. A method according to claim 1, wherein the board-shaped article (2) is inserted into longitudinal grooves (28) of two carrying arms (21) extending approximately parallel to the longitudinal edges (3) of the article (2), and the width adjustment of the carrying elements (20) is effected by adjusting at least one of the carrying arms (21) transversely to the direction of insertion of the article (2).

3. A method according to claim 2, wherein the adjusting movement of the carrying arm(s) (21) of the carrying elements (20) is braked.

4. A method according to any one of the preceding claims, wherein the coating is effected in a coating station (7;9) which is equipped with lateral guide means (19) for the longitudinal edges (3), which guide means are automatically adjusted to the width (B) of an article (2) to be coated, and wherein the width adjustment of the carrying elements (20) of the vapour-removal and drying station (8;10) is effected in dependence on the width adjustment of the lateral guide means (19) for the longitudinal edges (3) in the coating station (7;9).

5. A method according to claim 4, wherein the board-shaped article (2) is inserted from the lateral guide members (19) of the coating station (7;9) into the carrying elements (20) of the vapour-removal and drying station (8;10) by feed-in means (45) which are fixedly associated with the vapour-removal and drying station (8;10) at its entrance side and which can be operated preferably pneumatically.

6. A method according to claim 5, wherein the board-shaped article (2) is turned in a first vapour-removal and drying station (8), transferred to a second coating station (9) for coating the second side with preferably UV-hardenable plastics (C) or lacquer and then further transported to at least one other, second vapour-removal and drying station (10).

7. A method according to claim 6, wherein the board-shaped article (2) is guided or supported substantially constantly at the longitudinal edges (3) during its transport from the first coating station (7) to the exit of a final vapour-removal and drying station (8;10;11) of the coating installation (1) and during its transfer to the various transport means (17-20) of the individual processing stations.

8. A method according to claim 7, wherein during its transfer from the carrying elements (17) of a preheating station (6) arranged at the entrance to the coating installation (1) to the transport means (19) of the first coating station (7) the board-shaped article (2) is centred, and wherein after that first centring operation the board-shaped article (2) is supported or guided substantially constantly at the longitudinal edges (3) and is transported in that manner in an aligned position as far as the exit of the coating installation.

9. A method according to any one of the preceding claims, wherein the transport is effected in such a manner that substantially only the lacquer-free longitudinal edges (3) come into contact with the transport means (17-20) in the individual processing stations.

10. A method according to any one of the preceding claims, wherein, during transport through the vapour-removal and drying station(s) (8;10;11) and, where appropriate, during transport through a preheating station (6) provided at the entrance to the first coating station (7), the board-shaped article (2) is supported at at least one site on one of its transverse edges (4), preferably in a region that extends approximately from the first quarter over approximately the third quarter of the article (B), especially approximately in the region of halfway across the width (B).

11. A method according to any one of the preceding claims, wherein the width of the carrying elements (20) is adjusted electro-pneumatically.

12. An apparatus for coating a board-shaped article, especially a printed circuit board (2), comprising a preheating station (6) for the board-shaped article (2), which preheating station is arranged at the entrance to the apparatus, and following the preheating station, in the sequence of their arrangement, at least one coating station (7) for coating at least one side of the article (2) with preferably UV-hardenable plastics (C) or lacquer, and at least one vapour-removal and drying station (8), each of which processing stations has transport means (17-20) for the article (2), wherein the transport means (20) in the vapour-removal and drying station (8) comprise carrying elements for the longitudinal edges (3) of the article (2), the width of which carrying elements is adjustable to the width (B) of the article (2) to be carried and which support and guide the article (2) at the longitudinal edges (3) over its entire length, and wherein the transport means (18) that transport the board-shaped article (2) to the entrance of the vapour-removal and drying station (8) support and guide the board-shaped article (2) at the longitudinal edges (3) over its entire length.

13. An apparatus according to claim 12, wherein each carrying element (20) comprises two carrying arms (21) which extend approximately parallel to the longitudinal edges (3) of the boards, and at least one of the carrying arms (21) is displaceable transversely to the longitudinal extent of the carrying arms (21).

14. An apparatus according to claim 13, wherein each carrying element (20) is secured to two, preferably vertical, endless circulating roller chains (22) which are arranged opposite one another, the links (23) of which chains are provided in each case with drilled holes (24) for receiving preferably two guide rods (25,26) of approximately circular cross-section along which the carrying arms (21) are displaceable transversely to their longitudinal extent.

15. An apparatus according to claim 14, wherein the carrying arm (21) of each pair of carrying arms comprises a guide rail (27) having a longitudinal groove (28) of approximately V-shaped profile which is constructed to be open at its free end remote from the chain (22) and at its other end has a stop (31) for the transverse edge (4) of an inserted article (2), and wherein the guide rails (27) of each pair of carrying arms are so arranged that their longitudinal grooves (28) extend parallel to one another and face one another.

16. An apparatus according to claim 15, wherein the included angle (α) of the longitudinal groove is approximately from 30° to 50°, preferably approximately 40°.

17. An apparatus according to claim 15 or claim 16, wherein a support member (32) for the front transverse edge (4) of the inserted article (2) extends away from the guide rods (25,26), which guide member (32) is secured at the circumference of the guide rods in a region that extends from approximately the first quarter over approximately the third quarter of the length of the guide rods (25,26) and that is located preferably approximately in the region of halfway along the length of the guide rod, and which support member (32) extends below the plane of insertion (T) of the article (2) approximately as far as the rear end-face stop (31) in the longitudinal groove (28) of the guide rail (27).

18. An apparatus according to any one of claims 15 to 17, wherein each guide rail (27) is secured to a holding device (33) which is equipped with a drilled hole (34) for receiving the guide rod (25) that is at the front viewed in the direction of transport (D) of the article (2) and which holding device has at its rear end a fork-like guide member (35) which engages round the second, rear guide rod (26).

19. An apparatus according to claim 18, wherein the holding device (33) is equipped in the region of the drilled hole (34) with a running carriage (36) having a number of rollers (37) which are so arranged one behind the other along the circumference of the front guide rod (25) that the holding device (33) is displaceable along the front guide rod (25) without tilting.

20. An apparatus according to claim 19, wherein the running carriage (36) has six rollers (37) which are arranged in triplets one behind the other, and the regions of contact of the individual rollers (37) of each roller triplet with the first guide rod (25) are separated from one another at an angle (β) of approximately 120°.

21. An apparatus according to claim 19 or claim 20, wherein the running carriage (36) has a brake (38,39) which is preferably in the form of a spring-loaded brake block which presses against the front guide rod.

22. An apparatus according to any one of claims 18 to 21, wherein the holding device (33) has a stop (40), an extension or the like which can be coupled to and preferably releasably locked with preferably pneumatic adjusting means (44) for the transverse adjustment of the carrying arm (21).

23. An apparatus according to any one of claims 12 to 22, wherein there are provided at least at the entrance to the vapour-removal and drying station(s) (8;10;11) advancing means (45) which are fixedly associated with that(those) station(s), by means of which the article (2) can be inserted into the carrying elements (20).

24. An apparatus according to claim 23, wherein the advancing means (45) are arranged below the plane of transport (T) and comprise a displacing element (46) which can be moved preferably pneumatically in or counter to the direction of transport (D) and acts on the rear transverse edge (4) of the article (2).

25. An apparatus according to any one of claims 12 to 24, wherein the transport means (19) comprise in each coating station (7;9) lateral guide means (19) for the longitudinal edges (3), which guide means are adjustable automatically with preferably electropneumatic adjusting means to the width (B), whereby the article (2) can be centred in respect of its alignment with the pouring curtain in the coating station (7;9), and the adjusting means for the width adjustment of the carrying elements (20) of the vapour-removal and drying station(s) (8;10) and the adjusting means for the width adjustment of the lateral guide means (19) for the longitudinal edges (3) in the particular coating station (7;9) are coupled to one another.

26. An apparatus according to claim 25, wherein the transport means (17-20) of all the processing stations (6-11) of the coating installation (1) comprise carrying elements or guide means for the longitudinal edges (3), the width of which elements or means is automatically adjustable to the width (B) of the article (2), and wherein transfer devices are provided at the interfaces between the individual processing stations, which transfer devices are fixedly associated with the preceding or with the following processing station and by means of which the article (2), after passing through the preceding processing station, can be transferred to the following processing station, while being supported or guided substantially constantly at its longitudinal edges (3).

27. An apparatus according to any one of claims 12 to 26, which is constructed to provide coating on both sides, the article being turned in the preheating station (6) and in the vapour-removal and drying stations (8;10;11).

## Revendications

1. Procédé pour le revêtement d'objets en forme de cartes, en particulier de cartes à circuit imprimé (2) dans le cas duquel l'objet en forme de carte (2) est transporté à travers plusieurs stations de traitement successives (6-8; 8-10; 6-11) d'une installation de revêtement (1) dans lesquelles il est préchauffé, revêtu, sous forme humide et au moins sur une face, d'un plastique (C) ou d'une laque pouvant durcir de préférence aux rayons UV et, après chaque revêtement d'une face, admis à évaporation et à séchage, caractérisé par le fait que le produit en forme de carte (2) est, après chaque revêtement, transféré à des éléments porteurs (20) d'une station d'évaporation et de séchage (8;10) qui sont reliés avec elle, fixes par rapport à l'appareil, que la largeur des éléments porteurs (20) y est réglée sur la largeur (B) de l'objet à transporter et que l'objet en forme de carte (2) est, au moins à partir du première revêtement, soutenu et guidé sur toute sa longueur par les bords longitudinaux (3).

2. Procédé selon la revendication 1, caractérisé par le fait que l'objet en forme de carte (2) s'enfile dans des rainures longitudinales (28) de deux bras porteurs (21) qui sont orientés à peu près parallèlement aux bords longitudinaux (3) de l'objet (2) et que le réglage en largeur des éléments porteurs (20) se fait par déplacement d'au moins l'un des bras porteurs (21) perpendiculairement à la direction d'enfilage de l'objet (2).

3. Procédé selon la revendication 2, caractérisé par le fait que le mouvement de réglage du ou des bras porteurs (21) des éléments porteurs (20) est freiné.

4. Procédé selon l'une des revendications précédentes, caractérisé par le fait que le revêtement se fait dans une station de revêtement (7;9) qui est équipée, pour les bords longitudinaux (3), de moyens de guidage latéraux (19) qui se règlent chaque fois automatiquement sur la largeur (B) d'un objet (2) à revêtir et que le réglage en largeur des éléments porteurs (20) de la station d'évaporation de séchage (8;10) se fait en fonction du réglage en largeur des moyens de guidage latéraux (19) prévus pour les bords longitudinaux (3) dans la station de revêtement (7;9).

5. Procédé selon la revendication 4, caractérisé par le fait qu'à l'aide de moyens d'entrée (45) reliés, du côté entrée, avec la station d'évaporation de séchage (8;10), fixes par rapport à l'appareil, et de préférence manoeuvrables pneumatiquement, l'objet en forme de carte (2) s'enfile, depuis les guidages latéraux (19) de la station de revêtement (7;9), dans les éléments porteurs (20) de la station d'évaporation et de séchage (8;10).

6. Procédé selon la revendication 5, caractérisé par le fait que l'objet en forme de carte (2) est retourné dans une première station d'évaporation et de séchage (8), transféré à une seconde station de revêtement (9) pour le revêtement de la seconde face avec un plastique (C) ou une laque pouvant de préférence durcir aux rayons UV et, à la suite, transporté à au moins une autre seconde station d'évaporation et de séchage (10).

7. Procédé selon la revendication 6, caractérisé par le fait que, pendant son transport de la première station de revêtement (7) jusqu'à la sortie d'une station d'évaporation et de séchage (8;10;11), qui lui est reliée, de l'installation de revêtement (1) et pendant son transfert aux différents moyens de transport (17-20- des différentes stations de traitement, l'objet en forme de carte (2) est guidé ou soutenu essentiellement en permanence par les bords longitudinaux (3).

8. Procédé selon la revendication 7, caractérisé par le fait que l'objet en forme de carte (2) est centré lors du transfert, depuis les éléments porteurs (17) d'une station de préchauffage (6) disposée à l'entrée de l'installation de revêtement (1), aux moyens de transport (19) de la première station de revêtement (7), et qu'à partir de ce premier centrage, l'objet en forme de carte est soutenu ou guidé essentiellement en permanence par les bords longitudinaux (3) et transporté de cette façon en position orientée jusqu'à la sortie de l'installation de revêtement.

9. Procédé selon l'une des revendications précédentes, caractérisé par le fait que le transport se fait de façon qu'essentiellement seuls les bords longitudinaux (3), exempts de laque, viennent en contact avec les moyens de transport (17-20) dans les différentes stations de traitement.

10. Procédé selon l'une des revendications précédentes. caractérisé par le fait que, lors du transport à travers la ou les stations d'évaporation et de séchage (8;10;11) et éventuellement lors du transport à travers une installation de préchauffage (6) prévue à l'entrée de la première installation de revêtement (7), l'objet en forme de carte est soutenu en au moins un point sur l'un de ses bords transversaux (4), de préférence dans une zone qui s'étend à peu près à partir du premier quart jusqu'à environ le troisième quart de l'objet (B), en particulier à peu près dans la zone de la demi-largeur (B).

11. Procédé selon l'une des revendications précédentes, caractérisé par le fait que la largeur des éléments porteurs (20) se règle par voie électo-pneumatique.

12. Dispositif pour le revêtement d'un objet en forme de carte, en particulier de cartes à circuit imprimé (2) comportant une station de préchauffage (6), disposée du côté de l'entrée du dispositif, pour l'objet en forme de carte (2) et, à la suite de celle-ci, dans la succession de leur disposition, au moins une station de revêtement (7) pour le revêtement d'au moins une face de l'objet (2) avec un plastique (C) ou une laque de préférence durcissable aux rayons UV et au moins une station d'évaporation et de séchage (8), stations de traitement qui présentent chacune des moyens de transport (17-20) pour l'objet (2), caractérisé par le fait que les moyens de transport (20) dans la station d'évaporation et de séchage (8) comportent, pour les bords longitudinaux (3) de l'objet (2), des éléments porteurs dont la largeur est réglable sur la largeur (B) de l'objet à porter (2) et qui le soutiennent et le guident sur toute sa longueur par les bords longitudinaux (3), et que les moyens de transport (18) qui transportent l'objet en forme de carte (2) à l'entrée de la station d'évaporation et de séchage (8) soutiennent et guident l'objet en forme de carte (2) sur toute sa longueur par ses bords longitudinaux (3).

13. Dispositif selon la revendication 12, caractérisé par le fait que chaque élément porteur (20) comporte deux bras porteurs (21) orientés à peu près parallèlement aux bords longitudinaux (3) de la carte et qu'au moins l'un des bras porteurs (21) peut coulisser perpendiculairement à l'extension longitudinale des bras porteurs (21).

14. Dispositif selon la revendication 13, caractérisé par le fait que chaque élément porteur (20) est fixé à deux chaînes à rouleaux (22) qui sont situées en face l'une de l'autre, qui ont un mouvement tournant continu, de préférence vertical, et dont les maillons de chaîne (23) présentent chacun des perçages (24) pour recevoir de préférence deux tiges de guidage (25-26), de section à peu près circulaire, le long desquelles les bras porteurs (21) peuvent coulisser perpendiculairement à leur extension longitudinale.

15. Dispositif selon la revendication 14, caractérisé par le fait que le bras porteur (21) de chaque paire de bras porteurs comporte un rail de guidage (27) avec une rainure longitudinale (28) d'un profil à peu près en forme de V, qui est prévue ouverte, côté frontal, à son extrémité libre située du côté opposé à la chaîne (22 et, à son autre extrémité frontale, présente une butée (31) pour le bord transversal (4) d'un objet (2) enfilé, et que les rails de guidage (27) de chaque paire de bras porteurs sont disposés de façon que leurs rainures longitudinales (28) soient orientées parallèlement l'une à l'autre et tournées l'une vers l'autre.

16. Dispositif selon la revendication 15, caractérisé par le fait que l'angle d'ouverture (α) de la rainure longitudinale vaut environ 30°-50°, de préférence environ 40°.

17. Dispositif selon la revendication 15 ou 16, caractérisé par le fait qu'un organe d'appui (32) pour le bord transversal avant (4) de l'objet (2) enfilé s'étend depuis les tiges de guidage (25,26), organe de guidage (32) qui, dans une zone qui s'étend depuis à peu près le premier quart jusqu'à environ le troisième quart de la longueur des tiges de guidage (25,26) et se trouve de préférence à peu près au voisinage de la demi-longueur de la tige de guidage, est fixé à la périphérie des tiges de guidage et s'étend en dessous du plan d'enfilage (T) de l'objet (2), à peu près jusqu'à la butée frontale arrière (31) qui se trouve dans la rainure longitudinale (28) du rail de guidage (27).

18. Dispositif selon l'une des revendications 15-17, caractérisé par le fait que chaque rail de guidage (27) est fixé à un support (33) qui présente un perçage (34) pour recevoir la tige de guidage (25), avant dans le sens (D) de transport de l'objet (2), et qui présente à son extrémité arrière un guidage (35) en forme de fourchette qui enserre la seconde tige de guidage, arrière, (26).

19. Dispositif selon la revendication 18, caractérisé par le fait que le support (33) est équipé, dans la zone du perçage (34), d'un chariot (36) qui présente un certain nombre de galets (37) qui sont disposés, le long de la périphérie de la tige de guidage avant (25), et l'un derrière l'autre, de façon telle que le support (33) peut coulisser sans se coincer le long de la tige de guidage avant (25).

20. Dispositif selon la revendication 19, caractérisé par le fait que le chariot (36) présente six galets (37) qui sont respectivement disposés par groupe de trois l'un derrière l'autre et que les zones de contact des différents galets (37) de chaque groupe de trois galets avec la première tige de guidage (25) sont décalées l'une par rapport à l'autre d'un angle (β) valant environ 120°.

21. Dispositif selon la revendication 19 ou 20, caractérisé par le fait que le chariot (36) présente un frein (38,39) qui est de préférence conçu sous forme d'un sabot de frein, contraint par ressort, qui pousse contre la tige de guidage avant.

22. Dispositif selon l'une des revendications 18-21, caractérisé par le fait le support (33) présente une butée (40), un doigt ou analogue, qui peut se coupler avec des moyens de déplacement (44), de préférence pneumatiques, pour le déplacement transversal du bras porteur (21) et peut de préférence se verrouiller avec eux, avec possibilité de déverrouillage.

23. Dispositif selon l'une des revendications 12 à 22, caractérisé par le fait qu'au moins à l'entrée de la station ou des stations d'évaporation et de séchage (8;10;11) sont prévus des moyens d'avancement (45), fixes par rapport à l'appareil, à l'aide desquels l'objet (2) peut s'enfiler dans les éléments porteurs (20).

24. Dispositif selon la revendication 23, caractérisé par le fait que les moyens d'avancement (45) sont disposés à l'intérieur du plan de transport (T) et comportent un élément coulissant (46) qui peut se déplacer, de préférence pneumatiquement, dans le sens (D) du transport ou en sens inverse et qui intervient sur le bord transversal arrière (4) de l'objet (2).

25. Dispositif selon l'une des revendications 12-24, caractérisé par le fait que les moyens de transport (19) comportent, dans chaque station de revêtement (7:9), pour les bords longitudinaux (3), des moyens de guidage latéraux (19) qui, avec des moyens de réglage, de préférence électro-pneumatiques, peuvent chacun se régler automatiquement sur la largeur (B), ce par quoi l'objet (2) peut se centrer en ce qui concerne son orientation sur le rideau de coulée dans la station de revêtement (7;9) et que les moyens de réglage pour le réglage de la largeur des éléments porteurs (20) de la station ou des stations d'évaporation et de séchage (8;10) et les moyens de réglage pour le réglage de la largeur des moyens de guidage latéraux (19) pour les bords longitudinaux (3) dans la station de revêtement respectif (7;9)sont couplés les uns avec les autres.

26. Dispositif selon la revendication 25, caractérisé par le fait que les moyens de transport (17-20) de toutes les stations de traitement (6-11) de l'installation de revêtement (1) comportent, pour les bords longitudinaux (3), des éléments porteurs ou des moyens de guidage dont la largeur peut automatiquement se régler sur la largeur (B) de l'objet (2), et qu'aux interfaces entre les différentes stations de traitement sont prévus des dispositifs de transfert qui sont reliés, fixes par rapport à l'appareil, avec la station de traitement précédente ou avec la station de traitement suivante, et à l'aide desquels, après son parcours à travers la station de traitement précédente, l'objet (2) peut être transféré à la station de traitement suivante, étant précisé qu'il est soutenu ou guidé de façon essentiellement permanente par ses bords longitudinaux (3).

27. Dispositif selon l'une des revendications 12-26, caractérisé par le fait qu'il est conçu pour le revêtement sur les deux faces, l'objet étant chaque fois retourné dans la station de préchauffage (6) et dans les stations d'évaporation et de séchage (8;10;11).
